# EUROPEAN PATENT SPECIFICATION

(11) **EP 3 164 891 B1**
(45) Date of publication and mention of the grant of the patent: **29.08.2018**
(21) Application number: 15731978.1
(22) Date of filing: 01.07.2015
(51) Int. Cl.: H01L 31/049

(54) **MONO-BACKSHEET FOR SOLAR CELL MODULES**
MONO-RÜCKSEITENFOLIE FÜR SOLARZELLENMODULE
MONOFEUILLE DORSALE DE MODULES DE CELLULES SOLAIRES

(30) Priority: 04.07.2014 EP 14175784
(43) Date of publication of application: 10.05.2017
(73) Proprietor: DSM IP Assets B.V., 6411 TE Heerlen (NL)
(72) Inventor: DUIJNHOVEN VAN, Franciscus Gerardus Henricus, 6100 AA Echt (NL); MEIJERS, Guido Jozefina Wilhelmus, 6100 AA Echt (NL)
(74) Representative: DSM Intellectual Property
(86) International application number: PCT/EP2015/064937
(87) International publication number: WO 2016/001279

(56) References cited:
- EP-A1- 2 275 471
- US-A1- 2002 128 385

## Description

The present invention is directed to back sheets for solar cell modules. The present invention also relates to solar cell modules comprising such back sheet. Further, the present invention relates to a polymer composition that can be used to produce back sheets for solar cell modules.

Solar cell or photovoltaic modules are used to generate electrical energy from sunlight and consist of a laminate which contains a solar cell system as the core layer. This core layer (herein also referred to as solar cell layer) is encapsulated with encapsulating materials which serve as protection against mechanical and weathering-induced influences. These encapsulating materials can consist of one or more layers of plastic films and/or plastic composites.

Because they provide a sustainable energy resource, the use of solar cells is rapidly expanding. The more traditional solar cells are the wafer-based solar cells.

Monocrystalline silicon (c-Si), poly- or multi-crystalline silicon (poly-Si or mc-Si) and ribbon silicon are the materials used most commonly in forming the more traditional wafer-based solar cells. Solar cell modules derived from wafer-based solar cells often comprise a series of self-supporting wafers (or cells) that are soldered together. The wafers generally have a thickness of between about 180 and about 240 micron. Such a panel of solar cells is called a solar cell layer and it may further comprise electrical wirings such as cross ribbons connecting the individual cell units and bus bars having one end connected to the cells and the other exiting the module. The solar cell layer is then further laminated to encapsulant layer(s) and protective layer(s) to form a weather resistant module that may be used for at least 20 years. In general, a solar cell module derived from wafer-based solar cell(s) comprises, in order of position from the front sun-facing side to the back non-sun-facing side: (1) a transparent pane (representing the front sheet), (2) a front encapsulant layer, (3) a solar cell layer, (4) a back encapsulant layer, and (5) a backing layer (or back sheet, representing the rear protective layer of the module).

The encapsulant layers used in solar cell modules are designed to encapsulate and protect the fragile solar cells. Suitable polymer materials for solar cell encapsulant layers typically possess a combination of characteristics such as high impact resistance, high penetration resistance, good ultraviolet (UV) light resistance, good long term thermal stability, adequate adhesion strength to glass and/or other rigid polymeric sheets, high moisture resistance, and good long term weatherability. Currently, ethylene/vinyl acetate copolymers are the most widely used encapsulant material and polyvinylfluoride and polyethylene terephthalate are the most widely used materails for back sheets in the industry. EP2275471 A1 is considered the closest prior art and discloses a photovoltaic module mono-backsheet produced from a moulding compound based on at least one extruded polyamide. When solar cell modules are used in the field, it is found that if the encapsulant sheet and the back sheet are not tightly sealed, moisture tends to enter and cause de-lamination. There is thus still a need to develop an encapsulant and backsheet material having superior adhesion to each other and therefore improve the weatherability of the solar cell module.

In contrast to the prior art, which typically provides multilayered backsheets and adhered thereto a back encapsulant layer, the object of the present invention is to identify suitable materials that can be used for producing a monolayer for a solar-cell module to be used as backing layer which backing layer is connected to the lower sides of the solar cells. In the present invention, the backing monolayer integrates the function of the back encapsulant layer and the back sheet in one layer and is to be used as rear layer for a solar-cell module.

This object has been achieved in that backing monolayer is obtained or obtainable by melt-extruding a polymer composition comprising (a) a polyamide, (b) an elastomer and (c) an elastomer that contains groups that bond chemically and/or interact physically with the polyamide, and wherein the elastomer constitutes the continuous phase of the polymer composition and the polyamide constitutes the dispersed phase of the polymer composition, characterized in that the polymer composition comprises from 10 to 50 wt.% of the polyamide (a) and from 50 to 90 wt.% of the elastomer (b) and (c) (of the total weight of polyamide (a) and elastomer (b) and (c) present in the polymer composition).

It has surprisingly been found that by melt-extruding a polymer composition as claimed a monolayer can be obtained that is applicable as rear layer for a solar-cell module and that integrates the function of a back encapsulant layer and a back sheet. The use of one layer instead of several layers has several advantages such as no delamination, more simple production of the solar-cell module as at least one layer less needs to be laminated. Further the risk that moisture and/or oxygen enters between the rear backing layer and rear encapsulant layer during the production of the solar cell module is reduced and hence the risk for delamination and/or electrical breakdown is reduced.

An elastomer is herein mentioned means a polymeric compound with a Young's modulus (measured at 23°C according to ISO 527 1A) of from 2 MPa to 400 MPa. Preferably from 5 to 300 MPa, more preferably from 5 to 200 MPa and even more preferably from 5 to 100 MPa. An elastomer is called functionalized when it contains groups that bond chemically or interact physically with polyamide present in the polymer composition and/or with the solar cells.

The amount of groups present in the polymer composition that bond chemically and/or interact physically with the polyamide is preferably from 0.01 to 5 wt.%. The best results are generally achieved with a content of from 0.025 to 2 wt.% (of the total weight of the polymer composition), more preferably from 0.05 to 2 wt.%.The weight ratio of non-functionalized to functionalized elastomer in the polymer composition may vary within wide limits and is determined in part by the functional groups content of the elastomer and the available reactive groups in the polyamide polymer.

The polyamide that is present in the polymer composition is preferably selected from the group consisting of polyamide-6,6, polyamide-4,6 and polyamide-6 and any mixture thereof; more preferably the polyamide is polyamide-6.

The elastomer (b) of the polymer composition is preferably a copolymer of ethylene and C3-C12-α-olefin with a density of from 0.85 to 0.93 g/cm³ and a Melt Flow Index (ASTM D1238, 190 °C, 2.16 kg) of from 0.5 to 30 g/10 min. More preferably, the elastomer (b) of the polymer composition is an ethylene-octene copolymer with a density of from 0.85 to 0.93 g/cm³ and a Melt Flow Index (ASTM D1238, 190 °C, 2.16 kg) of from 0.5 to 30 g/10 min. Even more preferably, said ethylene-octene copolymer is obtained by polymerization in the presence of a metallocene catalyst since it was found that this results in improved compatibility of the polyamide and the elastomer in the polymer composition.

The elastomer (c) of the polymer composition is preferably a copolymer of ethylene and C3-C12-α-olefin with a density of from 0.85 to 0.93 g/cm³ and a Melt Flow Index (ASTM D1238, 190 °C, 2.16 kg) of from 0.5 to 30 g/10 min, which copolymer contains groups that bond chemically and/or interact physically with the polyamide. Preferably, the copolymer is an ethylene-octene copolymer with a density of from 0.85 to 0.93 g/cm³ and a Melt Flow Index (ASTM D1238, 190 °C, 2.16 kg) of from 0.5 to 30 g/10 min. Even more preferably, said ethylene-octene copolymer is obtained by polymerization in the presence of a metallocene catalyst since this results in improved compatibility of the polyamide and the elastomer in the polymer composition. The non-functionalized elastomer and the elastomer that is functionalized may be identical or different. An example of a suitable combination is an ethylene-octene copolymer and an ethylene-octene copolymer modified with for instance maleic anhydride.

In the present invention, an elastomer that contains groups that bond chemically and/or interact physically with the polyamide is present in the polymer composition. Preferably, the polymer composition comprises functionalized elastomer (c) that contains groups that bond chemically with the polyamide. Preferably, the groups that bond chemically with the polyamide are chosen from the group consisting of anhydrides, acids, epoxides, silanes, isocyanates, oxazolines, thiols and/or (meth)acrylates, with the proviso that the combination of silane and anhydride is preferably excluded, since the presence of silanes in combination with anhydrides may result in gelation of the polymer composition. More preferably, the groups that bond chemically with the polyamide are chosen from the group consisting of unsaturated dicarboxylic acid anhydrides, unsaturated dicarboxylic acids and unsaturated dicarboxylic acid esters and mixtures of the two or more thereof. Even more preferably, the groups that bond chemically with the polyamide are chosen from the group consisting of unsaturated dicarboxylic acid anhydrides. Most preferably, the elastomer that contains groups that bond chemically with the polyamide is obtained by graft polymerizing the elastomer with maleic acid, maleic anhydride and/or fumaric acid, preferably with maleic anhydride.

Functional groups can be introduced in the elastomer in many ways. Preferred ways are by chemical modification of the elastomer or by graft polymerization of the elastomer with components containing functional groups as defined hereinabove. Non-limiting and preferred examples of such components are unsaturated dicarboxylic acid anhydrides or an unsaturated dicarboxylic acid or an ester thereof, for instance maleic anhydride, maleic acid, fumaric acid, itaconic acid and itaconic anhydride; unsaturated epoxide such as glycidyl acrylate, for example glycidyl methacrylate; and unsaturated silanes such as for example vinyltrimethoxysilane, vinyltriethoxysilane, vinyltris(beta -methoxyethoxy)silane, gamma-methacryloxypropyltrimethoxysilane, vinyltriacetoxysilane, gammaglycidoxypropyltrimethoxysilane, gamma-glycidoxypropyltriethoxysilane, beta -(3,4-epoxycyclohexyl)ethyltrimethoxysilane, vinyltrichlorosilane or mixtures of two or more thereof.

The polymer composition used herein may further comprise one or more other polymers. Such optional polymer(s) may be present in an amount of up to about 25 wt percent, based on the total weight of the polymer composition, provided that the inclusion of such optional polymer(s) does not adversely affect the desirable performance characteristics of the polymer composition, such as the adhesion properties and the integrated function of back encapsulant layer and back sheet.

The polymer composition may further comprise additives known within the art. The first and second polymer composition preferably comprise at least one additive selected from UV stabilizers, UV absorbers, anti-oxidants, thermal stabilizers and/or hydrolysis stabilisers. When such additives stabilizers are used, the polymer composition contains from 0.05 wt. % percent to 10 wt.%, more preferably to 5 wt.%, based on the total weight of the polymer composition. Through the selection of the polyamide, the elastomer and the functional groups of the polymer composition from the described types and amounts, and the optional addition of one or more of these additives, the layer obtained by melt-extruding the first and second polymer composition fulfills all essential requirements for solar-cell module backing layer, such as weathering stability (UV and hydrolysis resistance), heat resistance, mechanical protection, electrical insulation and good adhesion.

White pigments such as TiO2, ZnO or ZnS may be added to the to monolayer to increase backscattering of sunlight leading to increased efficiency of the PV module. Black pigments such as carbon black may be added for esthetic reasons.

The thickness of the solar-cell module backing monolayer is preferably from 0.1 to 1 mm, more preferably from 0.1 to 0.8 mm, even more preferably from 0.1 to 0.75 mm.

The present invention further relates to the use of the melt-extruded sheet as described herein above as backing layer for a solar cell module, characterized in that the backing layer is the rear layer of the solar-cell module and the backing layer is connected to the lower sides of the solar cells.

The present invention further relates to a solar-cell module containing essentially, in order of position from the front-sun facing side to the back non-sun-facing side, a transparent pane, a front encapsulant layer, a solar cell layer comprised of one or more electrically interconnected solar cells, and a backing layer, wherein the backing layer is connected to the lower sides of the solar cells, characterized in that the backing layer is as defined herein above. The solar cells in the solar cell layer may be any kind of solar cells, such as thin-film solar cells (for example copper indium gallium selenide solar cells and cadmium telluride solar cells) and wafer- based solar cells.

The present invention further relates to a polymer composition comprising comprising (a) a polyamide, (b) an elastomer and (c) an elastomer that contains groups that bond chemically and/or interact physically with the polyamide, and wherein the elastomer constitutes the continuous phase of the polymer composition and the polyamide constitutes the dispersed phase of the polymer composition, characterized in that the polymer composition comprises from 10 to 50 wt.% of the polyamide (a) and from 50 to 90 wt.% of the elastomer (b) and (c) (of the total weight of polyamide (a) and elastomer (b) and (c) present in the polymer composition). Preferred embodiments for such a polymer composition are described herein above.

The invention is now demonstrated by means of a series of examples and comparative experiments.

**Table 1**

| Materials used | Description |
|---|---|
| ICOSOLAR® AAA 3554 obtained from Isovoltaic | Laminate of 3 polyamide layers |
| ICOSOLAR® 2442 obtained from Isovoltaic | Laminate of 3 layers: polyvinyl fluoride - polyethylene terephtalate - polyvinyl fluoride |
| APOLHYA® Solar R333A obtained from Arkema | Polyolefin back encapsulant - polyethylene with grafted polyamide |
| EVASKY™ from Bridgestone | Ethylene-vinyl acetate copolymer |
| Akulon® K122 from DSM | Polyamide-6 |
| Cupper Iodide powder obtained from BASF | Thermal stabilizer |
| Irganox® 1098 obtained from BASF | Anti-oxidant |
| Queo™ 8201 obtained from Borealis Plastomers | LLDPE (ethylene based octene elastomer) with density of 882 g/cm³ and MFI of 1 |
| Fusabond® N 525 obtained from DuPont | Anhydride modified ethylene copolymer (elastomer) |
| Glass plate from Centro Solar | SECURIT EN12150 |

### Comparative Experiment A

This example is a reference and only commercial encapsulant and backsheet films were used.

A laminate was made by making the following stack: 1) ICOSOLAR® AAA 3554, 2) APOLHYA® Solar R333A, 3) one standard multi-crystalline solar cell, 4) APOLHYA® Solar R333A, 5) glass plate of 20 by 30 cm. Lamination was done at 157 °C during 12 minutes.

Samples were aged in a climate chamber at 85 °C and 85% relative humidity. Samples were exposed to the damp heat test.

It was visually assessed that the sample showed no delamination during 3000 hours of ageing. It was assessed after 3000 hours of ageing, by hand, that the layer of ICOSOLAR® AAA 3554 became brittle between 2000 and 3000 hours of ageing. Flash testing did not show any significant decrease of the power output after 2000 hours of ageing.

### Comparative Experiment B

This example is a reference and only commercial encapsulant and backsheet films were used.

A laminate was made by making the following stack: 1) ICOSOLAR® AAA 3554, 2) EVASKY™ , 3) one standard multi-crystalline solar cell, 4) EVASKY™ 5) glass plate of 20 by 30 cm. Lamination was done at 157 °C during 12 minutes.

Samples were aged in a climate chamber at 85 °C and 85% relative humidity. Samples were exposed to the damp heat test.

It was visually assessed that the sample showed no delamination during 3000 hours of ageing. It was assessed after 3000 hours of ageing, by hand, that the layer of ICOSOLAR® AAA 3554 became brittle between 2000 and 3000 hours of ageing. Flash testing did not show any significant decrease of the power output after 2000 hours of ageing.

### Comparative Experiment C

This example is a reference and only commercial encapsulant and backsheet films were used.

A laminate was made by making the following stack: 1) ICOSOLAR® 2442, 2) EVASKY™, 3) one standard multi-crystalline solar cell, 4) EVASKY™, 5) glass plate of 20 by 30 cm. Lamination was done at 157 °C during 12 minutes.

Samples were aged in a climate chamber at 85 °C and 85% relative humidity.

It was visually assessed that the sample showed no delamination during 3000 hours of ageing. It was assessed after 3000 hours of ageing, by hand, that the layer of ICOSOLAR® 2442 became very brittle between 2000 and 3000 hours of ageing. Flash testing did not show any significant decrease of the power output after 2000 hours of ageing.

### Example 1

The following compound was made on a ZSK25 extruder: 25 wt% Akulon® K122, 61.85 wt% Queo™ 8201, 10 wt% Fusabond® N 525, 0.15 wt% Cupper Iodide, and 3 wt% Irganox® 1098. From the compound a 500 micrometer film was made via film-extrusion.

A laminate was made by making the following stack: 1)film of above compound, 2) one standard multi-crystalline solar cell, 3) APOLHYA® Solar R333A and 4) glass plate of 20 by 30 cm. Lamination was done at 157 °C during 12 minutes.

Samples were aged in a climate chamber at 85 °C and 85% relative humidity. Samples were exposed to the damp heat test.

It was visually assessed that the sample showed no delamination during 3000 hours of ageing. Flash testing did not show any significant decrease of the power output after 3000 hours of ageing.

### Example 2

The following compound was made on a ZSK25 extruder: 10 wt% Akulon® K122, 76.85 wt% Queo™ 8201, 10 wt% Fusabond® N 525, 0.15 wt% Cupper Iodide, and 3 wt% Irganox® 1098. From the compound a 500 micrometer film was made via film-extrusion.

A laminate was made by making the following stack: 1)film of above compound, 2) one standard multi-crystalline solar cell, 3) APOLHYA® Solar R333A, 4) glass plate of 20 by 30 cm. Lamination was done at 157 °C during 12 minutes.

Samples were aged in a climate chamber at 85 °C and 85% relative humidity. Samples were exposed to the damp heat test.

It was visually assessed that the sample showed no delamination during 3000 hours of ageing. Flash testing did not show any significant decrease of the power output after 3000 hours of ageing.

## Claims

1. A solar-cell module backing monolayer obtained by melt-extruding a polymer composition comprising (a) a polyamide, (b) an elastomer and (c) an elastomer that contains groups that bond chemically and/or interact physically with the polyamide, and wherein the elastomer constitutes the continuous phase of the polymer composition and the polyamide constitutes the dispersed phase of the polymer composition, **characterized in that** the polymer composition comprises from 10 to 50 wt.% of the polyamide (a) and from 50 to 90 wt.% of the elastomer (b) and (c) (of the total weight of polyamide (a) and elastomer (b) and (c) present in the polymer composition).

2. A backing monolayer according to claim 1, **characterized in that** the amount of groups that bond chemically or interact physically with the polyamide is from 0.025 to 2 wt.% (of the total weight of the polymer composition), preferably from 0.05 to 2 wt.%.

3. A backing monolayer according to claim 1 or 2, **characterized in that** the polyamide is selected from the group consisting of polyamide-6,6, polyamide-4,6 and polyamide-6 and any mixture thereof.

4. A backing monolayer according to any of preceding claims, **characterized in that** the elastomer (b) is a copolymer of ethylene and C3-C12-α-olefin with a density of from 0.85 to 0.93 g/cm³ and a Melt Flow Index (ASTM D1238, 190 °C, 2.16 kg) of from 0.5 to 30 g/10 min.

5. A backing monolayer according to claim 4, **characterized in that** the copolymer of ethylene and α-olefin is an ethylene-octene copolymer.

6. A backing monolayer according to claim 5, **characterized in that** the ethylene-octene copolymer is obtained by polymerization in the presence of a metallocene catalyst.

7. A backing monolayer according to any of the preceding claims, **characterized in that** the polymer composition comprises functionalized elastomer (c) that contains groups that bond chemically with the polyamide.

8. A backing monolayer according to claim 7, **characterized in that** the groups that bond chemically with the polyamide are chosen from the group consisting of anhydrides, acids, epoxides, silanes, isocyanates, oxazolines, thiols and/or (meth)acrylates.

9. A backing monolayer according to claim 7, **characterized in that** the groups that bond chemically with the polyamide are chosen from the group consisting of unsaturated dicarboxylic acid anhydrides, unsaturated dicarboxylic acids and unsaturated dicarboxylic acid esters and mixtures of the two or more thereof.

10. A backing monolayer according to claim 7, **characterized in that** the groups that bond chemically with the polyamide are chosen from the group consisting of unsaturated dicarboxylic acid anhydrides.

11. A backing monolayer according to claim 7, **characterized in that** the functionalized elastomer (c) is obtained by graft polymerizing elastomer with maleic acid, maleic anhydride and/or fumaric acid.

12. A backing monolayer according to any of the preceding claims, **characterized in that** the composition further comprise at least one additive selected from UV stabilizers, UV absorbers, anti-oxidants, heat stabilizers and/or hydrolysis stabilisers.

13. Polymer composition comprising (a) a polyamide, (b) an elastomer and (c) an elastomer that contains groups that bond chemically and/or interact physically with the polyamide, and wherein the elastomer constitutes the continuous phase of the polymer composition and the polyamide constitutes the dispersed phase of the polymer composition, whereby the polymer composition comprises from 10 to 50 wt.% of the polyamide (a) and from 50 to 90 wt.% of the elastomer (b) and (c) (of the total weight of polyamide (a) and elastomer (b) and (c) present in the polymer composition,and whereby the elastomer (b) is a copolymer of ethylene and C3-C12-α-olefin with a density from 0.85 to 0.93 g/cm³ and a Melt Flow Index (ASTM D1238, 190 °C, 2.16 kg) of from 0.5 to 30 g/10 min.

14. Polymer composition according to claim 13, **characterized in that** the copolymer of ethylene and C3-C12-α-olefin is an ethylene-octene copolymer.

15. Polymer composition according to claim 14, **characterized in that** the ethylene-octene copolymer is obtained by polymerization in the presence of a metallocene catalyst.

16. Polymer composition according to any of claims 13-15, **characterized in that** the polymer composition comprises functionalized elastomer (c) that contains groups that bond chemically with the polyamide.

17. Polymer composition according to claim 16, **characterized in that** the groups that bond chemically with the polyamide are chosen from the group consisting of anhydrides, acids, epoxides, silanes, isocyanates, oxazolines, thiols and/or (meth)acrylates.

18. Polymer composition according to claim 16, **characterized in that** the groups that bond chemically with the polyamide are chosen from the group consisting of unsaturated dicarboxylic acid anhydrides, unsaturated dicarboxylic acids and unsaturated dicarboxylic acid esters and mixtures of the two or more thereof.

19. Polymer composition according to claim 16, **characterized in that** the groups that bond chemically with the polyamide are chosen from the group consisting of unsaturated dicarboxylic acid anhydrides.

20. Polymer composition according to claim 16, **characterized in that** the functionalized elastomer (c) is obtained by graft polymerizing elastomer with maleic acid, maleic anhydride and/or fumaric acid, preferably with maleic anhydride.

21. A solar-cell module containing essentially, in order of position from the front-sun facing side to the back non-sun-facing side, a transparent pane, a front encapsulant layer, a solar cell layer comprised of one or more electrically interconnected solar cells, and a backing layer, wherein the backing layer is connected to the lower sides of the solar cells, **characterized in that** the backing layer is a monolayer obtained by melt-extruding a polymer composition as claimed in any of claims 13-20.

22. A solar-cell module according to claim 21, **characterized in that** the solar cells in the solar cell layer are wafer-based solar cells.

23. Use of the melt extruded layer according to any of claims 1-12 as backing layer for a solar cell module, **characterized in that** the backing layer is the rear layer of the solar-cell module and the backing layer is connected to the lower sides of the solar cells.

## Patentansprüche

1. Solarzellenmodul-Rückseitenmonoschicht, erhalten durch Schmelzeextrudieren einer Polymerzusammensetzung, umfassend (a) ein Polyamid, (b) ein Elastomer und (c) ein Elastomer, das Gruppen enthält, die chemisch an das Polyamid binden und/oder physikalisch mit dem Polyamid wechselwirken, und wobei das Elastomer die kontinuierliche Phase der Polymerzusammensetzung bildet und das Polyamid die disperse Phase der Polymerzusammensetzung bildet, **dadurch gekennzeichnet, dass** die Polymerzusammensetzung 10 bis 50 Gew.-% des Polyamids (a) und 50 bis 90 Gew.-% des Elastomers (b) und (c) (des Gesamtgewichts von Polyamid (a) und Elastomer (b) und (c) in der Polymerzusammensetzung) umfasst.

2. Rückseitenmonoschicht nach Anspruch 1, **dadurch gekennzeichnet, dass** die Menge von Gruppen, die chemisch an das Polyamid binden oder physikalisch mit dem Polyamid wechselwirken, 0,025 bis 2 Gew.-% (des Gesamtgewichts der Polymerzusammensetzung) und vorzugsweise 0,05 bis 2 Gew.-% beträgt.

3. Rückseitenmonoschicht nach Anspruch 1 oder 2, **dadurch gekennzeichnet, dass** das Polyamid aus der Gruppe bestehend aus Polyamid-6,6, Polyamid-4,6 und Polyamid-6 und einer beliebigen Mischung davon ausgewählt ist.

4. Rückseitenmonoschicht nach einem der vorhergehenden Ansprüche, **dadurch gekennzeichnet, dass** es sich bei dem Elastomer (b) um ein Copolymer von Ethylen und einem C3-C12-α-olefin mit einer Dichte von 0,85 bis 0,93 g/cm³ und einem Schmelzflussindex (Melt Flow Index, ASTM D1238, 190 °C, 2,16 kg) von 0,5 bis 30 g/10 min handelt.

5. Rückseitenmonoschicht nach Anspruch 4, **dadurch gekennzeichnet, dass** es sich bei dem Copolymer von Ethylen und α-Olefin um ein Ethylen-Octen-Copolymer handelt.

6. Rückseitenmonoschicht nach Anspruch 5, **dadurch gekennzeichnet, dass** das Ethylen-Octen-Copolymer durch Polymerisation in Gegenwart eines Metallocen-Katalysators erhalten wird.

7. Rückseitenmonoschicht nach einem der vorhergehenden Ansprüche, **dadurch gekennzeichnet, dass** die Polymerzusammensetzung funktionalisiertes Elastomer (c), das Gruppen enthält, die chemisch an das Polyamid binden, umfasst.

8. Rückseitenmonoschicht nach Anspruch 7, **dadurch gekennzeichnet, dass** die Gruppen, die chemisch an das Polyamid binden, aus der Gruppe bestehend aus Anhydriden, Säuren, Epoxiden, Silanen, Isocyanaten, Oxazolinen, Thiolen und/oder (Meth)-acrylaten ausgewählt sind.

9. Rückseitenmonoschicht nach Anspruch 7, **dadurch gekennzeichnet, dass** die Gruppen, die chemisch an das Polyamid binden, aus der Gruppe bestehend aus ungesättigten Dicarbonsäureanhydriden, ungesättigten Dicarbonsäuren und ungesättigten Dicarbonsäureestern und Mischungen von zwei oder mehr davon ausgewählt sind.

10. Rückseitenmonoschicht nach Anspruch 7, **dadurch gekennzeichnet, dass** die Gruppen, die chemisch an das Polyamid binden, aus der Gruppe bestehend aus ungesättigten Dicarbonsäureanhydriden ausgewählt sind.

11. Rückseitenmonoschicht nach Anspruch 7, **dadurch gekennzeichnet, dass** das funktionalisierte Elastomer (c) durch Pfropfpolymerisation von Elastomer mit Maleinsäure, Maleinsäureanhydrid und/oder Fumarsäure erhalten wird.

12. Rückseitenmonoschicht nach einem der vorhergehenden Ansprüche, **dadurch gekennzeichnet, dass** die Zusammensetzung ferner mindestens ein Additiv, das aus UV-Stabilisatoren, UV-Absorbern, Antioxidantien, Wärmestabilisatoren und/oder Hydrolysestabilisatoren ausgewählt ist, umfasst.

13. Polymerzusammensetzung, umfassend (a) ein Polyamid, (b) ein Elastomer und (c) ein Elastomer, das Gruppen enthält, die chemisch an das Polyamid binden und/oder physikalisch mit dem Polyamid wechselwirken, und wobei das Elastomer die kontinuierliche Phase der Polymerzusammensetzung bildet und das Polyamid die disperse Phase der Polymerzusammensetzung bildet, wobei die Polymerzusammensetzung 10 bis 50 Gew.-% des Polyamids (a) und 50 bis 90 Gew.-% des Elastomers (b) und (c) (des Gesamtgewichts vom Polyamid (a) und Elastomer (b) und (c) in der Polymerzusammensetzung) umfasst und wobei es sich bei dem Elastomer (b) um ein Copolymer von Ethylen und einem C3-C12-α-olefin mit einer Dichte von 0,85 bis 0,93 g/cm³ und einem Schmelzflussindex (Melt Flow Index, ASTM D1238, 190 °C, 2,16 kg) von 0,5 bis 30 g/10 min handelt.

14. Polymerzusammensetzung nach Anspruch 13, **dadurch gekennzeichnet, dass** es sich bei dem Copolymer von Ethylen und C3-C12-α-olefin um ein Ethylen-Octen-Copolymer handelt.

15. Polymerzusammensetzung nach Anspruch 14, **dadurch gekennzeichnet, dass** das Ethylen-Octen-Copolymer durch Polymerisation in Gegenwart eines Metallocen-Katalysators erhalten wird.

16. Polymerzusammensetzung nach einem der Ansprüche 13-15, **dadurch gekennzeichnet, dass** die Polymerzusammensetzung funktionalisiertes Elastomer (c), das Gruppen enthält, die chemisch an das Polyamid binden, umfasst.

17. Polymerzusammensetzung nach Anspruch 16, **dadurch gekennzeichnet, dass** die Gruppen, die chemisch an das Polyamid binden, aus der Gruppe bestehend aus Anhydriden, Säuren, Epoxiden, Silanen, Isocyanaten, Oxazolinen, Thiolen und/oder (Meth)-acrylaten ausgewählt sind.

18. Polymerzusammensetzung nach Anspruch 16, **dadurch gekennzeichnet, dass** die Gruppen, die chemisch an das Polyamid binden, aus der Gruppe bestehend aus ungesättigten Dicarbonsäureanhydriden, ungesättigten Dicarbonsäuren und ungesättigten Dicarbonsäureestern und Mischungen von zwei oder mehr davon ausgewählt sind.

19. Polymerzusammensetzung nach Anspruch 16, **dadurch gekennzeichnet, dass** die Gruppen, die chemisch an das Polyamid binden, aus der Gruppe bestehend aus ungesättigten Dicarbonsäureanhydriden ausgewählt sind.

20. Polymerzusammensetzung nach Anspruch 16, **dadurch gekennzeichnet, dass** das funktionalisierte Elastomer (c) durch Pfropfpolymerisation von Elastomer mit Maleinsäure, Maleinsäureanhydrid und/oder Fumarsäure, vorzugsweise mit Maleinsäureanhydrid, erhalten wird.

21. Solarzellenmodul, im Wesentlichen enthaltend, in der Reihenfolge der Position von der der Sonne zugewandten Vorderseite zur nicht der Sonne zugewandten Rückseite, eine transparente Scheibe, eine vordere Verkapselungsmittelschicht, eine Solarzellenschicht, die aus einer oder mehreren elektrisch miteinander verbundenen Solarzellen besteht, und eine Rückseitenschicht, wobei die Rückseitenschicht mit den unteren Seiten der Solarzellen verbunden ist, **dadurch gekennzeichnet, dass** es sich bei der Rückseitenschicht um eine durch Schmelzeextrudieren einer Polymerzusammensetzung nach einem der Ansprüche 13-20 erhaltene Monoschicht handelt.

22. Solarzellenmodul nach Anspruch 21, **dadurch gekennzeichnet, dass** es sich bei den Solarzellen in der Solarzellenschicht um Wafer-basierte Solarzellen handelt.

23. Verwendung der schmelzeextrudierten Schicht nach einem der Ansprüche 1-12 als Rückseitenschicht für ein Solarzellenmodul, **dadurch gekennzeichnet, dass** es sich bei der Rückseitenschicht um die rückseitige Schicht des Solarzellenmoduls handelt und die Rückseitenschicht mit den unteren Seiten der Solarzellen verbunden ist.

## Revendications

1. Monocouche de support de module de cellules solaires obtenue par extrusion à l'état fondu d'une composition de polymères comprenant (a) un polyamide, (b) un élastomère et (c) un élastomère qui contient des groupes qui se lient chimiquement au polyamide et/ou interagissent physiquement avec celui-ci et dans laquelle l'élastomère constitue la phase continue de la composition de polymères et le polyamide constitue la phase dispersée de la composition de polymères, **caractérisée en ce que** la composition de polymères comprend de 10 à 50 % en poids du polyamide (a) et de 50 à 90 % en poids de l'élastomère (b) et (c) (par rapport au poids total de polyamide (a) et d'élastomère (b) et (c) présents dans la composition de polymères).

2. Monocouche de support selon la revendication 1, **caractérisée en ce que** la quantité de groupes qui se lient chimiquement au polyamide ou interagissent physiquement avec celui-ci est de 0,025 à 2 % en poids (par rapport au poids total de la composition de polymères), de préférence de 0,05 à 2 % en poids.

3. Monocouche de support selon la revendication 1 ou 2, **caractérisée en ce que** le polyamide est choisi dans le groupe constitué par le polyamide-6,6, le polyamide-4,6 et le polyamide-6 et un quelconque mélange de ceux-ci.

4. Monocouche de support selon l'une quelconque des revendications précédentes, **caractérisée en ce que** l'élastomère (b) est un copolymère d'éthylène et d'a-oléfine en C3-C12 ayant une masse volumique de 0,85 à 0,93 g/cm³ et un indice de fluidité à chaud (selon la norme ASTM D1238, à 190 °C, sous 2,16 kg) de 0,5 à 30 g/10 min.

5. Monocouche de support selon la revendication 4, **caractérisée en ce que** le copolymère d'éthylène et d'α-oléfine est un copolymère d'éthylène-octène.

6. Monocouche de support selon la revendication 5, **caractérisée en ce que** le copolymère d'éthylène-octène est obtenu par polymérisation en présence d'un catalyseur métallocène.

7. Monocouche de support selon l'une quelconque des revendications précédentes, **caractérisée en ce que** la composition de polymères comprend un élastomère fonctionnalisé (c) qui contient des groupes qui se lient chimiquement au polyamide.

8. Monocouche de support selon la revendication 7, **caractérisée en ce que** les groupes qui se lient chimiquement au polyamide sont choisis dans le groupe constitué par les anhydrides, les acides, les époxydes, les silanes, les isocyanates, les oxazolines, les thiols et/ou les (méth)acrylates.

9. Monocouche de support selon la revendication 7, **caractérisée en ce que** les groupes qui se lient chimiquement au polyamide sont choisis dans le groupe constitué par les anhydrides d'acides dicarboxyliques insaturés, les acides dicarboxyliques insaturés et les esters d'acides dicarboxyliques insaturés et les mélanges de deux ou plus de deux de ceux-ci.

10. Monocouche de support selon la revendication 7, **caractérisée en ce que** les groupes qui se lient chimiquement au polyamide sont choisis dans le groupe constitué par les anhydrides d'acides dicarboxyliques insaturés.

11. Monocouche de support selon la revendication 7, **caractérisée en ce que** l'élastomère fonctionnalisé (c) est obtenu par polymérisation par greffage d'un élastomère avec de l'acide maléique, de l'anhydride maléique et/ou de l'acide fumarique.

12. Monocouche de support selon l'une quelconque des revendications précédentes, **caractérisée en ce que** la composition comprend en outre au moins un additif choisi parmi les stabilisants vis-à-vis des UV, les absorbeurs d'UV, les antioxydants, les stabilisants vis-à-vis de la chaleur et/ou les stabilisants vis-à-vis de l'hydrolyse.

13. Composition de polymères comprenant (a) un polyamide, (b) un élastomère et (c) un élastomère qui contient des groupes qui se lient chimiquement au polyamide et/ou interagissent physiquement avec celui-ci et dans laquelle l'élastomère constitue la phase continue de la composition de polymères et le polyamide constitue la phase dispersée de la composition de polymères, la composition de polymères comprenant de 10 à 50 % en poids du polyamide (a) et de 50 à 90 % en poids de l'élastomère (b) et (c) (par rapport au poids total de polyamide (a) et d'élastomère (b) et (c) présents dans la composition de polymères) et l'élastomère (b) étant un copolymère d'éthylène et d'α-oléfine en C3-C12 ayant une masse volumique de 0,85 à 0,93 g/cm³ et un indice de fluidité à chaud (selon la norme ASTM D1238, à 190 °C, sous 2,16 kg) de 0,5 à 30 g/10 min.

14. Composition de polymères selon la revendication 13, **caractérisée en ce que** le copolymère d'éthylène et d'α-oléfine en C3-C12 est un copolymère d'éthylène-octène.

15. Composition de polymères selon la revendication 14, **caractérisée en ce que** le copolymère d'éthylène-octène est obtenu par polymérisation en présence d'un catalyseur métallocène.

16. Composition de polymères selon l'une quelconque des revendications 13-15, **caractérisée en ce que** la composition de polymères comprend un élastomère fonctionnalisé (c) qui contient des groupes qui se lient chimiquement au polyamide.

17. Composition de polymères selon la revendication 16, **caractérisée en ce que** les groupes qui se lient chimiquement au polyamide sont choisis dans le groupe constitué par les anhydrides, les acides, les époxydes, les silanes, les isocyanates, les oxazolines, les thiols et/ou les (méth)acrylates.

18. Composition de polymères selon la revendication 16, **caractérisée en ce que** les groupes qui se lient chimiquement au polyamide sont choisis dans le groupe constitué par les anhydrides d'acides dicarboxyliques insaturés, les acides dicarboxyliques insaturés et les esters d'acides dicarboxyliques insaturés et les mélanges de deux ou plus de deux de ceux-ci.

19. Composition de polymères selon la revendication 16, **caractérisée en ce que** les groupes qui se lient chimiquement au polyamide sont choisis dans le groupe constitué par les anhydrides d'acides dicarboxyliques insaturés.

20. Composition de polymères selon la revendication 16, **caractérisée en ce que** l'élastomère fonctionnalisé (c) est obtenu par polymérisation par greffage d'un élastomère avec de l'acide maléique, de l'anhydride maléique et/ou de l'acide fumarique, de préférence avec de l'anhydride maléique.

21. Module de cellules solaires contenant essentiellement, dans l'ordre du côté avant faisant face au soleil au côté arrière ne faisant pas face au soleil, une vitre transparente, une couche avant de matériau d'encapsulation, une couche de cellules solaires constituée d'une ou plusieurs cellules solaires électriquement connectées entre elles et une couche de support, dans lequel la couche de support est reliée aux côtés inférieurs des cellules solaires, **caractérisé en ce que** la couche de support est une monocouche obtenue par extrusion à l'état fondu d'une composition de polymères telle que revendiquée dans l'une quelconque des revendications 13-20.

22. Module de cellules solaires selon la revendication 21, **caractérisé en ce que** les cellules solaires dans la couche de cellules solaires sont des cellules solaires à base de tranches.

23. Utilisation de la couche extrudée à l'état fondu selon l'une quelconque des revendications 1-12 en tant que couche de support pour un module de cellules solaires, **caractérisée en ce que** la couche de support est la couche arrière du module de cellules solaires et la couche de support est reliée aux côtés inférieurs des cellules solaires.
